# EUROPEAN PATENT APPLICATION

(11) **EP 2 589 488 A1**
(43) Date of publication of application: **08.05.2013**
(21) Application number: 13152979.4
(22) Date of filing: 05.04.2010
(51) Int. Cl.: B32B 15/04, H05K 3/02, B32B 37/12, B65H 31/02, B65H 39/00

(54) **Rectangular laminated body**

(30) Priority: 22.12.2009 JP 2009290424
(62) Divisional of application: 10773529.2
(71) Applicant: JX Nippon Mining & Metals Corporation, Tokyo 100-8164 (JP)
(72) Inventor: Takamori, Masayuki, Chiyoda-ku, Tokyo 100-8164 (JP)
(74) Representative: Hoarton, Lloyd Douglas Charles

(57) **Abstract**

This invention provides a carrier-attached copper foil to be used upon producing a laminated plate, and aims to realize the improvement in the handling ability in the production process of a printed board and cost reduction based on an improved production yield.

## Description

### TECHNICAL FIELD

The present invention relates to a method of producing a laminated body configured from a carrier-attached copper foil that is used in producing a single-sided or multilayer laminated body of two or more layers for use in a print wiring board, and also relates to a laminated body obtained thereby.

### BACKGROUND ART

A typical example of a multilayer laminated body is a printed circuit board. Generally, a printed circuit board is basically configured from a dielectric material referred to as a "prepreg" that is obtained by impregnating synthetic resin in a base material such as a synthetic resin plate, glass plate, nonwoven glass fabric or paper.
A sheet such as a copper or copper alloy foil having electrical conductivity is bonded to the prepreg surface (front and back surfaces). A laminate that is assembled as described above is generally referred to as a CCL (Copper Clad Laminate) material. When copper foils are multi-layered on the CCL material via the prepreg, this is referred to as a multilayer board.
Other foils made of aluminum, nickel, zinc or the like may also be used in substitute for the copper or copper alloy foil. The foil thickness is roughly 5 to 200 µm.

In the foregoing process, a carrier-attached copper foil is used for the purpose of preventing the adhesion of foreign matter on the surface of the copper foil and for the purpose of improving the handling ability.
For example, in the method of producing a four-layer substrate using a conventionally known carrier-attached copper foil (refer to Patent Documents 2, 3 and 4), an ultrathin copper foil to which a carrier is peelably bonded is mounted on a stainless pressing plate (so called "mirror plate") having a flat pressing surface with a thickness of 0.2 to 2 mm so that the M surface (rough surface) is on top, subsequently a prescribed number of prepregs, subsequently a printed circuit board in which a circuit is formed on a CCL material referred to as the inner layer core, subsequently a prepreg, and subsequently an ultrathin copper foil to which a carrier is peelably bonded are mounted so that the M surface (rough surface) is at the bottom, and, by laminating these in the order of the mirror plate, an assembled unit configured from one set of a four-layer substrate material is thereby complete.

Subsequently, these units (so-called "pages") are repeatedly laminated 2 to 10 times to configure a press assembly (so-called "book"). Subsequently, the foregoing book is placed on a hot plate in the hot press and subject to compression molding at a prescribed temperature and pressure to produce a laminated plate. Substrates with four or more layers can be produced with a similar process by increasing the number of layers of the inner layer core.
Here, with the carrier-attached copper foil to be used, since the ultrathin copper foil and the carrier are bonded across the entire surface, there is a problem in that peeling the carrier after lamination requires the worker considerable force and much time (refer to Patent Document 9). In addition, as described above, upon performing the lay-up (lamination assembly) operation, the worker needs to alternatively repeat the process of lamination so that the M surface of the copper foil is on top or the M surface is at the bottom, and there is a problem in that the work efficiency will deteriorate. Moreover, since the copper foil and the carrier are of the same size, it is difficult to peel one copper foil at a time during the lay-up, and there is also a problem in that the workability deteriorates with respect to this point.

Furthermore, as described in Patent Document 1, upon producing a circuit board using CAC having a structure in which a copper foil is bonded to the front and back surfaces of an aluminum plate, an aluminum plate (JIS#5182) is used as a part of the CAC material, However, since the linear expansion coefficient of the aluminum plate is 23.8 × 10⁻⁶/°C and great in comparison to the copper foil (16.5 × 10⁻⁶/°C) as the constituent material of the substrate and the polymerized prepreg (C stage: 12 to 18 × 10⁻⁶/°C), a phenomenon (scaling change) where the board size before and after pressing is different than the designed size will occur. This will lead to the misalignment of the circuit in the in-plane direction, and there is a problem in that this will become a cause for deteriorating the production yield.

The linear expansion coefficient (normal temperature) of the various materials that are used in the print wiring board is as follows. It is evident that the linear expansion coefficient of the aluminum plate is considerably greater than the other materials.
- Copperfoil: 16.5 (× 10⁻⁶/°C)
- SUS304: 17.3 × 10⁻⁶/°C
- SUS301: 15.2 × 10⁻⁶/°C
- SUS630: 11.6 × 10⁻⁶/°C
- Prepreg (C stage): 12 to 18 × 10⁻⁶/°C
- Aluminum plate (JIS#5182): 23.8 × 10⁻⁶/°C
   Although not directly related to the present invention, there are the following documents as examples related to a carrier-attached ultrathin copper foil (refer to Patent Document 2, Patent Document 3, and Patent Document 4).

Meanwhile, there is a proposal of a carrier foil and copper foil bonded body in which two sides are bonded and fixed via ultrasonic welding or the like (refer to Patent Document 5). Even upon producing this carrier foil and copper foil bonded body in which two sides are bonded and fixed via ultrasonic welding or the like, the air-vent process is required as with the other foregoing documents, but it is difficult to vent air without creating wrinkles. The reason for this is that, pursuant to the misalignment between the sheets upon pressing the sheets with a rotary roller and squeezing out air, stress is accumulated at the fixed bond part to which no misalignment will occur, and will be subject to defects such as wrinkles or cracks.

It is relatively easy to bond a copper foil to a strong carrier with rigidity (refer to Patent Documents 6, 7 and 8). When a copper foil is aligned for bonding with a strong carrier, an air layer exists between the aligned carrier and copper foil or carrier-attached copper foil immediately after such alignment, however, it will not result in a convex shape as with a sheet copper foil, but air-vent is gradually realized as a result of the copper foil being piled together since the carrier is rigid.
Nevertheless, a rigid carrier also entails its own problem. Specifically, since the carrier is highly rigid, when the bonding is performed in an easily peelable manner, the copper foil and carrier will instantaneously become separated and then undergo deflection during the handling or the like, and air is sucked into the gap. Thus, dust and foreign matter get sucked into the gap. In other words, a rigid carrier has a problem in that it is subject to a bellows effect.

Moreover, Patent Document 9 proposes a carrier-attached copper foil that is configured to be bonded across its entire surface, but in this case there is a problem in that the peeling strength will rise and the peeling process will become difficult. There is also a problem in that deflection will occur during the handling thereof and air and foreign matter get mixed in from the portion that is bonded weakly due to the foregoing deflection. The problems of these Patent Documents will be explained in detail later in the comparison with the present invention.

### [Patent Documents]

[Patent Document 1] Japanese Patent No. 3100983
[Patent Document 2] Japanese Published Unexamined Application No. 2005-161840
[Patent Document 3] Japanese Published Unexamined Application No. 2007-186797
[Patent Document 4] Japanese Published Unexamined Application No. 2001-140090
[Patent Document 5] Japanese Published Unexamined Application No. H10-291080
[Patent Document 6] Japanese Published Unexamined Application No. 2002-134817
[Patent Document 7] International Publication No.WO 2007-012871
[Patent Document 8] Japanese Translation of PCT International Application Publication No.H6-510399
[Patent Document 9] Japanese Published Unexamined Application No. 2001-68804

### DISCLOSURE OF INVENTION

### [Problems which the Invention Intends to Solve]

The present invention was devised in view of the foregoing circumstances, and relates to a method of producing a laminated body configured from a carrier-attached copper foil that is used in producing a single-sided or multilayer laminated body of two or more layers for use in a print wiring board, and to a laminated body obtained thereby, and particularly relates to the production of a carrier-attached copper foil to be used upon producing a laminated plate. Thus, an object of this invention is to realize improvement in the handling ability in the production process of a printed board and cost reduction based on an improved production yield.

### [Means for Solving the Problems]

As a result of intense study to achieve the foregoing object, the present inventors discovered that the method of producing a laminated body can be considerably improved based on the production process; specifically, based on the selection and application method of an adhesive.
Based on this discovery, the present invention provides:
1) A method of producing a laminated body, wherein, while winding off a carrier A from a bobbin, an adhesive is applied to both facing ends thereof, a metal foil B is laid on and bonded to a side to which the adhesive was applied while being wound off from a bobbin, the obtained laminated body is subsequently cut, the cut laminated bodies are aligned, a roller is applied from the top of an object to be cut configured from the aligned laminated bodies when the elevation of the center of the object to be cut becomes high to vent air existing between the objects to be cut and in the laminated bodies, and the adhesive is eventually hardened to mutually bond the laminated bodies;
2) The method of producing a laminated body according to paragraph 1) above, wherein the roller is applied from the top of the object to be cut when the elevation of the center of the object to be cut configured from the aligned laminated bodies becomes greater than 10% of the thickness of four sides;
3) The method of producing a laminated body according to paragraph 1) or paragraph 2) above, wherein a carrier A having proof stress or yield stress of 20 to 500 N/mm² is used, and the carrier A and the metal foil B are bonded at ends of two facing sides with an adhesive having an adhesive strength of 5 g/cm to 500 g/cm in order to produce a rectangular laminated body in which the carrier A and the metal foil B alternately overlap;
4) The method of producing a laminated body according to any one of paragraphs 1) to 3) above, wherein an adhesive to be applied and used for bonding has a viscosity of 3,000,000 mPA•S (25°C) or less in the process of applying a roller from the top of the object to be cut and removing air existing between the objects to be cut and in the laminated bodies;
5) The method of producing a laminated body according to any one of paragraphs 1) to 3) above, wherein an adhesive to be applied and used for bonding has a viscosity of 1,000,000 mPA·S (25°C) or less in the process of applying a roller from the top of the object to be cut and removing air existing between the objects to be cut and in the laminated bodies;
6) The method of producing a laminated body according to any one of paragraphs 1) to 5) above, wherein [the adhesive] is applied at a portion other than an area to be used as a printed circuit board of the metal foil B for bonding the carrier A and the metal foil B;
7) The method of producing a laminated body according to any one of paragraphs 1) to 6) above, wherein the adhesive is applied in dots or linearly; and
8) The method of producing a laminated body according to any one of paragraphs 1) to 7) above, wherein the position of applying the adhesive is disposed more outward than a laminated substrate material of a prepreg and/or core material to be subsequently bonded.

The present invention additionally provides:
8) A rectangular laminated body in which a carrier A and a metal foil B alternately overlap, wherein proof stress or yield stress of the carrier A is 20 to 500 N/mm2, and the carrier A and the metal foil B are bonded at ends of two facing sides with an adhesive having an adhesive strength of 5 g/cm to 500 g/cm;
9) A rectangular laminated body in which a carrier A and a metal foil B alternately overlap, wherein proof stress or yield stress of the carrier A is 20 to 500 N/mm², and the carrier A and the metal foil B are bonded at ends of two facing sides with an adhesive having an adhesive strength of 5 g/cm to 500 g/cm;
10) The laminated body according to paragraph 9) above, wherein an adhesive having a viscosity of 3,000,000 mPA·S (25°C) or less after the lapse of three minutes from application is used;
11) The laminated body according to paragraph 9) above, wherein an adhesive having a viscosity of 1,000,000 mPA·S (25°C) or less after the lapse of three minutes from application is used;
12) The laminated body according to any one of paragraphs 9) to 11) above, wherein the adhesive is epoxy-based, acrylic, methacrylate-based, silicon rubber-based, ceramic-based, or rubber-based;
13) The laminated body according to any one of paragraphs 9) to 12) above, wherein the metal foil B is a copper foil, a copper alloy foil, an aluminum foil, a nickel foil, a zinc foil, an iron foil, or a stainless foil, and its thickness is 1 to 100 µm;
14) The laminated body according to any one of paragraphs 9) to 13) above, wherein the same foil as the metal foil B is used as the carrier A;
15) The laminated body according to any one of paragraphs 9) to 14) above, wherein the adhesive is applied to a portion other than an area to be used as a printed circuit board of the metal foil B, and the carrier A and the metal foil B are bonded at such portion;
16) The laminated body according to any one of paragraphs 9) to 15) above, wherein the adhesive is applied in dots or linearly; and
17) The laminated body according to any one of paragraphs 9) to 16) above, wherein the position of applying the adhesive is disposed more outward than a laminated substrate material of a prepreg and/or core material to be subsequently bonded.

### [Effect of the Invention]

The carrier-attached metal foil of the present invention is a rectangular laminated body in which a carrier A and a metal foil B alternately overlap, wherein proof stress or yield stress of the carrier A is 20 to 500 N/mm², and the carrier A and the metal foil B are bonded at ends of two facing sides with an adhesive having an adhesive strength of 5 g/cm to 500 g/cm. Thus, the worker's handling ability will improve, and peeling can also be performed easily. In addition, it is possible to provide a production method that is free from wrinkles, cracks and peeling in the air-vent process. Moreover, since the misalignment of the circuit will not occur, the present invention yields a superior effect of being able to reduce defective products and thereby improve the production yield.

### BRIEF DESCRIPTION OF THE DRAWINGS

[Fig. 1] An explanatory diagram of a conventional method of producing a sheet copper foil which, after setting a copper foil coil (bobbin), the copper foil is wound off a prescribed length while sliding across a table.
[Fig. 2] An explanatory diagram showing that an air layer exists between the aligned sheet copper foils, and gradually presents an appearance of a convex shape.
[Fig. 3] An explanatory diagram for performing the air-vent operation each time a prescribed amount of sheet is cut.
[Fig. 4] A schematic diagram showing the production process in the present invention, and an explanatory diagram showing a state where, after setting the copper foil and the carrier coil and respectively winding off the same, an adhesive is applied to both ends in the feed direction and the copper foil and the carrier foil are thereafter bonded.
[Fig. 5] An explanatory diagram showing a state of forming the outermost copper foil layer by hot pressing a carrier-attached copper foil that is prepared by laminating a copper foil, a prepreg, a core material, and a copper foil in order, and further mutually bonding a carrier A and a metal foil B.
[Fig. 6] An explanatory diagram showing a state of performing the air-vent process on a flat table a prescribed amount of sheet is cut.
[Fig. 7] A schematic diagram showing the production process in the present invention; specifically, the process of setting the copper foil and the carrier coil and thereafter respectively winding off the same, applying an adhesive to both ends in the feed direction on the carrier and subsequently bonding the copper foil and the carrier foil.

### BEST MODE FOR CARRYING OUT THE INVENTION

Generally, a printed circuit board is basically configured from a dielectric material referred to as a "prepreg" that is obtained by impregnating synthetic resin in a base material such as a synthetic resin plate, glass plate, nonwoven glass fabric or paper. A sheet such as a copper or copper alloy foil having electrical conductivity is bonded between the prepregs. A laminate that is assembled as described above is generally referred to as a CCL (Copper Clad Laminate) material. When copper foils are multi-layered on the CCL material via the prepreg, this is referred to as a multilayer board. Other foils made of aluminum, nickel, zinc or the like are sometimes used in substitute for the copper or copper alloy foil, but such use is rare. In the foregoing case, the foil thickness is roughly 5 to 200 µm.

Generally, the operation of alternately handling the prepreg and the copper foil is performed in the lay-up process, which is the preceding process of copper foil lamination. Here, fine prepreg powder gets dispersed all around and accumulates on the respective materials during the lay-up operation, which is the operation of alternately overlaying the copper foil, the prepreg, and the core material. In particular, if the foregoing powder adheres to the copper foil, it will considerably affect the subsequent processes.
In the foregoing case, the prepreg powder that adhered to the S surface of the copper foil will melt due to the temperature and pressure during the lamination, and the area thereof will expand several hundredfold. For example, the prepreg powder having a diameter of several ten microns will expand to 1 mmϕ or more after lamination, and it is known to cause an open or short circuit in the circuit formation of the subsequent process.

Moreover, it has been confirmed that fine powder of approximately several ten prepregs generally adheres to a copper foil of 400 × 500 mm in the lay-up process. Thus, as the characteristics that are demanded in a carrier-attached copper foil, it is vital that the S surface is not exposed to the atmosphere of the lay-up chamber in the lay-up process. Ideally, it is necessary to adopt a configuration of bonding the entire surface of the carrier and copper foil with strong adhesion.

Meanwhile, the dismantling operation of separating the SUS intermediate plate and the laminated substrate after lamination is contrarily demanded of weak adhesion between the carrier and copper foil with easy peelability in order to perform the operation quickly. From this perspective, it is preferable that the bonding area is minimal and the adhesive strength is low.
The present invention was devised after intense study to seek a solution for the contradicting demands described above, and its object is to provide a configuration of a carrier-attached copper foil bonded with extremely weak adhesion and a method of producing the same.

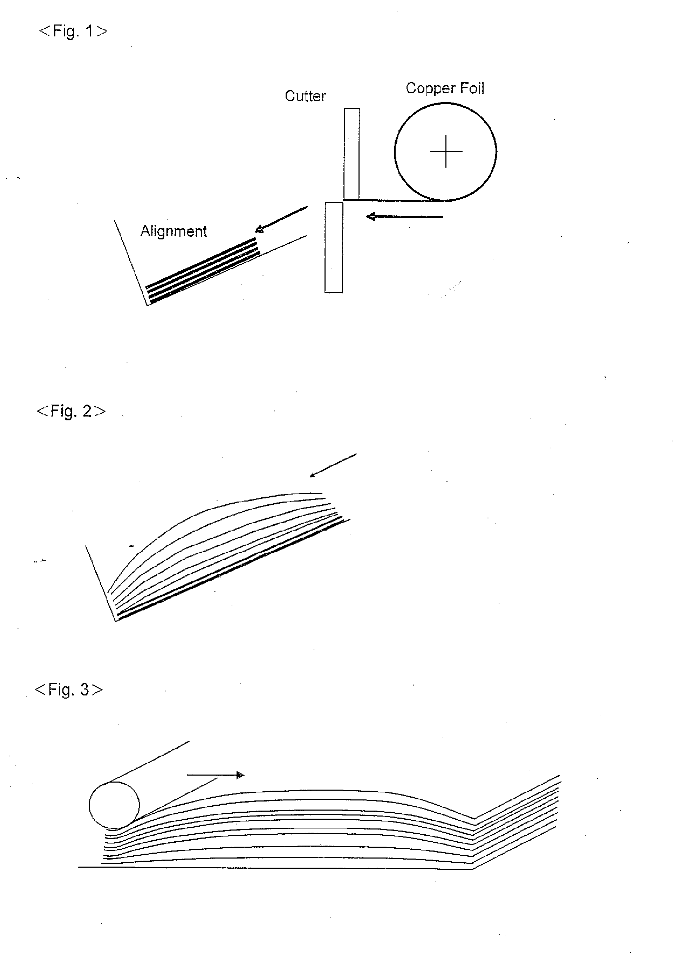

With a conventional method of producing a sheet copper foil, as shown in Fig. 1, after setting the copper foil coil, the copper foil is wound off a prescribed length while sliding across a table.
A thin air layer is formed under the copper foil upon causing it to move while sliding across the table. The copper foil is cut with a cutter at the moment when the move is suspended, and then aligned.
A new copper foil and a carrier material are thereafter wound off, and the carrier-attached copper foil is piled together as needed by repeating the foregoing process. Here, an air layer exists between the aligned sheet copper foils, and the appearance of a convex shape as shown in Fig. 2 will gradually appear. Consequently, it becomes difficult for the copper foil to slide and the continuation of alignment becomes impossible.

As a measure against the foregoing problem, the air-vent operation is performed each time a prescribed amount of sheet is cut. This process is shown in Fig. 3.
The air between the sheets is squeezed and released by pressing and rolling a roller on the aligned sheets while causing it to rotate. The convex shape after alignment is thereby flattened, and the sheet cutting process can be continued. This operation is also generally performed in the operation of cutting paper.

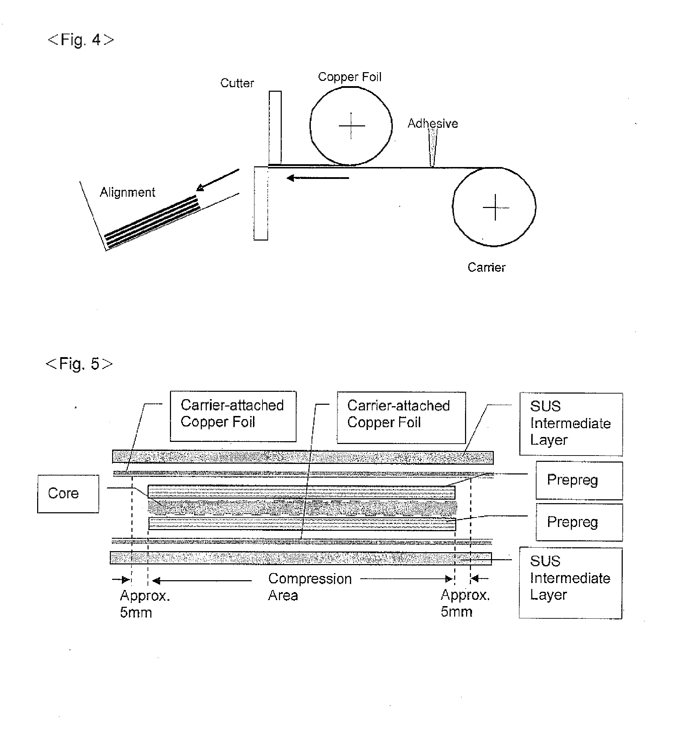

Fig. 4 is a schematic diagram of the production process in the present invention. After setting the copper foil and the carrier coil and respectively winding off the same, as shown in Fig. 4, an adhesive is applied to both ends in the feed direction and the copper foil and the carrier foil are thereafter bonded. The adhesive to be used here may be inorganic-based, organic-based, synthetic-based, or the like.
Fig. 5 is an explanatory diagram showing a state of forming the outermost copper foil layer by hot pressing a carrier-attached copper foil that is prepared by laminating a copper foil, a prepreg, a core material, and a copper foil in order, and further mutually bonding a carrier A and a metal foil B, and the application position of the adhesive is preferably located roughly 5 mm outside the size of the prepreg as shown in Fig. 5. This is in consideration to prevent the adhesive from being thrust into the compression area during lamination.

In other words, if the adhesive is placed in this area, the pressure will be concentrated at that point depending on the thickness; there is a drawback in that the pressure will not be applied on the other portions. The copper foil and the carrier are thereafter wound off a prescribed length while sliding across the table. A thin air layer is formed under the copper foil upon causing it to move while sliding across the table.
The copper foil is cut with a cutter at the moment when the move is suspended. A new copper foil and a carrier material are thereafter wound off, and the carrier-attached copper foil is piled together as needed by repeating the foregoing process.

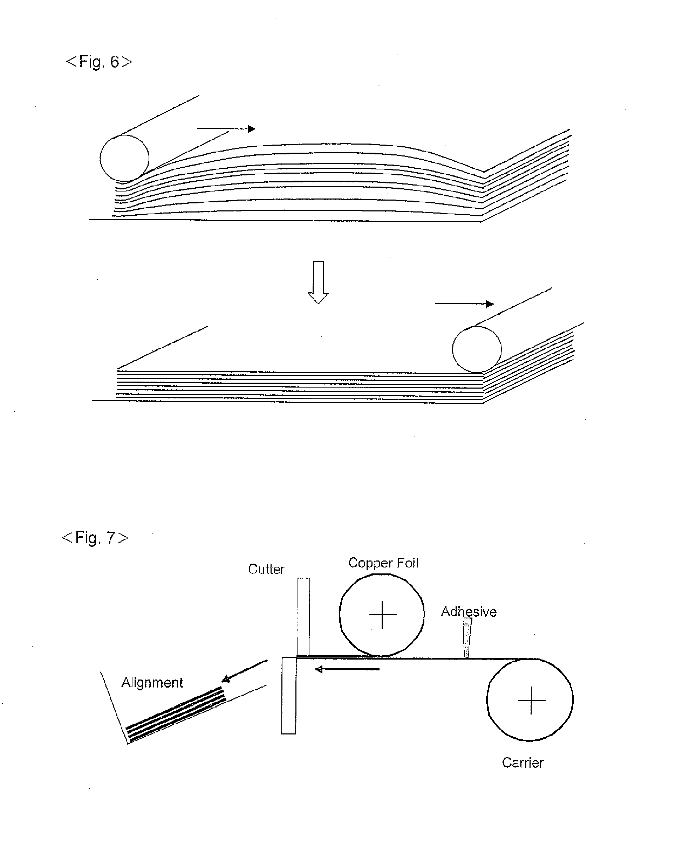

An air layer exists between the aligned carrier and copper foil, and the appearance of a convex shape as shown in Fig. 6 will gradually appear. Consequently, it becomes difficult for the carrier-attached copper foil to slide and the continuation of alignment becomes impossible.
If the adhesive is hardened in this state, the carrier-attached copper foil will be fixed in a convex shape and it is obvious that defects such as wrinkles will occur in the lamination process.

Accordingly, the carrier-attached copper foil must be aligned flatly before the adhesive is hardened. As a measure against the problem, the air-vent operation is performed each time a prescribed amount of sheet is cut. This process is shown in Fig. 6. As shown in Fig. 6, the air between the sheets is squeezed out and released by pressing and rolling a roller on the aligned sheets while causing it to rotate.

The convex shape after alignment is thereby flattened, and the sheet cutting process can be continued. Nevertheless, when producing a carrier-attached copper foil that is fixed and bonded at two sides via a swage, rivet, ultrasonic welding, double-sided adhesive tape or the like, it is difficult to vent air in the foregoing air-vent operation without the generation of wrinkles.
The reason for this is that, pursuant to the misalignment between the carrier and the copper foil upon pressing them with a rotary roller and squeezing out air, stress is accumulated at the fixed bond part to which no misalignment will occur, and will be subject to defects such as wrinkles or cracks.

For example, even upon producing this carrier foil and copper foil bonded body in which two sides are bonded and fixed via ultrasonic welding or the like, the air-vent process is required as with Patent Document 5 described above, but it is difficult to vent air without creating wrinkles.
The reason for this is that, pursuant to the misalignment between the sheets upon pressing the sheets with a rotary roller and squeezing out air, stress is accumulated at the fixed bond part to which no misalignment will occur, and will be subject to defects such as wrinkles or cracks.

The present invention uses an adhesive with easy peelability having an adhesive strength of 500 g/cm or less in order to alleviate the burden of the lay-up worker in the dismantling process, and if this adhesive is hardened before venting air, the bonding will peel as described above pursuant to the misalignment between the sheets during the air-vent, or, if the bonding does not peel, then defects such as wrinkles or cracks will occur.

Meanwhile, as shown in Patent Document 6, Patent Document 7, and Patent Document 8, it is relatively easy to bond a copper foil to a strong carrier with rigidity. The reason for this is as follows. When a copper foil is aligned for bonding with a strong carrier, an air layer exists between the aligned carrier and copper foil or carrier-attached copper foil immediately after such alignment. However, since the carrier is rigid, it will not result in a convex shape as with a sheet copper foil, and air-vent is gradually realized as a result of the copper foil being piled together.

The present invention relates to a process of producing a laminated body by applying an adhesive having an adhesive strength of 500 g/cm or less and bonding two sides of a carrier with a thickness of 1 to 100 µm, and the difficulty of the air-vent process is considerably higher in comparison to a case of bonding a copper foil to a strong carrier.
In other words, from the perspective of adhesive strength, if air is vented after the adhesive is hardened; the copper foil and the carrier will peel due to easy peelability thereof.
The present invention was devised in view of this point, and its object is to provide a method of producing a laminated body that is free from wrinkles, cracks and peeling in the air-vent process.

Fig. 7 is a schematic diagram showing the production process in the present invention. After setting the copper foil and the carrier coil, they are respectively wound off thereafter, and an adhesive is applied to both ends in the feed direction on the carrier and the copper foil and the carrier foil are subsequently bonded as shown in Fig. 7.
The application position of the adhesive is preferably located roughly 5 mm outside the size of the prepreg, which aims to avoid the influence of the thickness of the bond part. For example, if the bond part is provided to the core material or the prepreg area, the bond part will be transferred to the laminated substrate surface. And the pressure will be concentrated on such bond part in the pressing process but will not be applied to the other areas.

The adhesive to be used here is characterized in that it is hardened after the air-vent operation. The copper foil and the carrier are thereafter wound off a prescribed length while sliding on the air layer across the table or the cut copper foil, cut with a cutter at the moment when the move is suspended. A new copper foil and a carrier material are thereafter wound off, and the carrier-attached copper foil is piled together as needed by repeating the foregoing process.

Here, an air layer exists between the aligned carrier and copper foil, and the appearance of a convex shape as shown in Fig. 6 will gradually appear. Since the carrier-attached copper foil of the present invention is closed at two sides thereof, it is difficult for the air to escape, and the convex shape during the alignment will be more than double compared to the case of a sheet copper foil.

Subsequently, the air between the sheets is squeezed and released by pressing a roller on the aligned sheets on a flat table (this is hereafter referred to as "air-vent"). Here, since the adhesive of the carrier-attached copper foil has not hardened, the carrier and the copper foil will slip and mutually alleviate the stress upon squeezing out the air, or the carrier and the copper foil will once peel due to stress and once again be bonded with the rotary roller after cancelling such stress, and defects such as the generation of wrinkles or cracks will not occur.

Here, if the viscosity of the adhesive is too high, it will become difficult for the carrier and the copper foil to slip and mutually alleviate the stress, or for the carrier and the copper foil to once peel due to stress and once again be bonded with the rotary roller after cancelling such stress, and the generation of wrinkles or cracks will occur.
Here, shear stress will arise in the adhesive between the copper foils due to the misalignment, and the present inventors considered that the viscosity obtained from such shear stress and the rate of misalignment equals 'shear stress/rate of misalignment' could become an appropriate index for the generation of wrinkles or cracks.
As a result of repeating experiments, the present inventors discovered that it is possible to reduce the generation of wrinkles and cracks if the viscosity of the adhesive at the point of air-vent is 3,000,000 mPA·S (25°C) or less. Particularly, the viscosity of the adhesive is preferably 1,000,000 mPA·S (25°C) or less in the case of normal metal foils or carriers of a soft material.

In fact, if there is a certain level of adhesion and adhesive strength after hardening, the viscosity upon air-vent is preferably as low as possible. Under normal circumstances, it would be more preferable that the viscosity is 10,000 [m]PA•S (25°C) or less, and it may also be the level equivalent to the viscosity of water, for instance; namely, approximately 1 mPA·S (25°C) or less.
Contrarily, even if the viscosity is high, if a hard material or a combination of a copper foil and carrier with a thickness exceeding 10 µm is used, the viscosity will suffice if it is 3,000,000 mPA·S (25°C) or less, and if a soft material or a combination of a copper foil and carrier with a thickness of 10 µm or less is used, the viscosity will suffice if it is 1,00,000 mPA•S (25°C) or less, which is similar to a newly pound sticky rice cake.

The time when air is vented after application of the adhesive will vary depending on the device, but it is usually performed within one to several seconds. Some adhesives are gradually hardened and others quickly become hardened after application. Since the viscosity will increase pursuant to the hardening, as a result of thumb for selecting the adhesive, an adhesive having a viscosity of 3,000,000 mPA·S (25°C) or less, and preferably 1,000,000 mPA•S (25°C) or less after three minutes is used. The adhesive is hardened after performing the process of squeezing air out as described above.
As a result of the above, the convex shape of the aligned sheets can be flattened easily, and the sheet cutting process can be continued. Meanwhile, from the perspective of air elimination, the adhesive is preferably designed in a dotted line rather than a solid line.

The present invention relates to a carrier-attached copper foil that is produced by applying an adhesive with easy peelability at two opposing sides. A characteristic of this feature is that the adhesive strength will not rise due to the dispersion of the adhesive since a two-layered structure is adopted where the adhesive is not applied between the carrier and copper foil at the area that is used as the substrate (core material, or prepreg-area).

A carrier-attached copper foil configured to be bonded across its entire surface is well known (Patent Document 9). The specification of this Patent Document shows that the following drawbacks occur as a result of a bonding layer being provided to the entire surface. Due to the rise in the lamination temperature, the dispersion of the carrier and copper foil is advanced with certainty. This is verified by the fact that the peeling strength is rising according to the lapse of the retention time in the Examples of this Patent Document. Accordingly, it is easy to assume that, in reality, the worker's load will increase with certainty pursuant to the rise in the press temperature.

There is also a difference in that the carrier-attached copper foil configured to be bonded across its entire surface (Patent Document 9) is configured from three layers, and the area to which pressure is applied during the lamination (core material, or prepreg-area) is configured from two layers. Since the basic configuration is different and the bonding is also limited to two sides, pressure will not be applied during the lamination. Further, there is no concern for the adhesive strength to rise due to the dispersion of the adhesive since a two-layered structure is adopted where the adhesive is not applied between the carrier and copper foil at the area to which pressure is applied during the lamination (core material, or prepreg-area). This point is a characteristic of the present invention.

In addition, another effect is that the corrosion resistance applied to the copper foil can be maintained. A copper foil is generally subject to a corrosion resistance layer (chromate treatment or the like) of several Å on its surface. Since the corrosion resistance effect is retained even after the peeling of the carrier material in the present invention, the laminated body can be handled normally even after the lamination process without having to worry about the occurrence of corrosion.
Contrarily, with the carrier-attached copper foil configured to be bonded across its entire surface (Patent Document 9), since the copper surface is exposed to air during the peeling process, corrosion will occur easily. Or a new corrosion resistance process may be required for prevention of the occurrence of corrosion, which is a drawback of increasing the process load.

Moreover, since the present invention is able to use a product produced with a normal process as the copper foil, using a highly reliable copper foil is possible after confirming the existence of pin holes. With the carrier-attached copper foil configured to be bonded across its entire surface (Patent Document 9), it is not possible to detect pin holes due to its structure.
Generally, there are various types of pin holes of the copper foil ranging from several submicrometers to several hundred micrometers. Since the present invention is able to adopt a highly reliable mass-produced copper foil, it is possible to discover pin holes by adopting conventional methods such as the method of optically detecting transmitted light with AOI or a penetrant test, and uses a product that passed adequate quality testing.

With the carrier-attached copper foil configured to be bonded across its entire surface (Patent Document 9), it is not possible to adopt the light transmission method or the penetration method due to its structure. Since the pin holes can only be discovered after peeling the carrier material subsequent to the lamination process, risk will be assumed by that much.
The advantages of the carrier that is used in the present invention are in the thin foil and the consequential flexibility, and this prevents foreign matter from getting included between the carrier and the copper foil, as well as reduces the dents after lamination. The carrier foil of this invention preferably deforms flexibly together with the copper foil.

The flexible carrier material that is used in the present invention provides favorable support for a thin foil of 1 to 100 µm, and is able to eliminate the bellows effect compared to a rigid-type carrier with a thickness of 100 µm or more.
The reason for this is that, since the carrier is highly rigid, when the bonding is performed in an easily peelable manner, the copper foil and carrier will instantaneously become separated and then undergoes deflection during the handling or the like, and air is sucked into the gap. Consequently, dust and foreign matter get sucked into the gap; namely, it is subject to a bellows effect.

As a result of foreign matter such as dust and prepreg powder getting included between the copper foil and the carrier, dents and adhesion of prepregs will occur on the surface of the multilayer board after lamination. Meanwhile, the carrier of the present invention using the flexible thin foil will adhere due to the negative pressure that is generated when the copper foil is warped, and is able to follow the copper foil lithely.
Thus, the carrier and copper foil can be handled without peeling, and foreign matter such as dust and prepreg powder will not get included between the copper foil and the carrier. Accordingly, the present invention is characterized in that the copper foil and the carrier only need to be bonded at two opposing sides, and does not require complete sealing.

For example, a carrier-attached copper foil that is weakly bonded across its entire surface is explained. When handling the carrier-attached copper foil, the opposing ends are held with both hands and raised. Here, the overall carrier-attached copper foil will warp in a U shape. The curvature of this warp will be maximum near the center of the bonded body, and stress caused by the difference between the inner and outer circumferences is applied between the copper foil/carrier material of such warped portion; that is, if the inner side is the carrier and the outer side is the copper foil, the carrier will be subject to compressive stress and the copper foil will be subject to tensile stress.

Here, since the bonding between the copper foil and the carrier is a weak bond, if the stress exceeds the adhesive strength, the bond part will peel and air and foreign matter will instantaneously get included therein. Foreign matter will get included at the center part, and consequently numerous dents caused by the prepreg powder will arise at the center of the substrate after lamination.
Meanwhile, the same will occur when four sides are bonded linearly in a surrounding manner. The center part will warp in a U shape as with the foregoing case even at the sides that are 90 degrees relative to the two sides to be handled, and consequently the bonding will peel due to the stress caused by the difference between the inner and outer circumferences, and foreign matter will instantaneously get included therein.

As a result of repeating these experiments, the present inventors discovered that it is effective to bond two opposing sides. Specifically, a bonded body that is bonded at two sides will deform in a U shape when handled by holding the bonded sides. However, since the other portions are not bonded, the stress caused by the difference between the inner and outer circumferences will be canceled by the side slipping of the copper foil and the carrier; that is, the stress caused by the difference in the circumferences is thereby absorbed.

The flexible carrier material that is used in the present invention provides favorable support for the thin foil, and is able to eliminate the inclusion of foreign matter caused by the bellows effect compared to a rigid-type carrier.
Moreover, in order to facilitate the confirmation of the bonded sides, the carrier material of the bonded sides is caused to protrude to improve the convenience in handling the same. This supports the worker by presenting such worker from holding sides other than the two bonded sides, and this can also be used as a cue for the peeling process in the dismantling operation after the lamination, and yields the effect of facilitating the dismantling operation.

Under normal circumstances, the carrier A and the metal foil B are formed in a rectangular shape (oblong or square). Although this shape is arbitrary so as long as it is convenient in the handling during the manufacture, a square shape or a rectangular shape is generally used.
In addition, from the perspective of handling in the piling process, desirably one side of the carrier A and one side of the metal foil B are mutually aligned, or two adjacent sides or two opposing sides of the carrier A and the metal foil B are mutually aligned. The foregoing selection is also arbitrary.

With the carrier-attached metal foil of the present invention, a preferred mode is the metal foil B being a copper foil or a copper alloy foil, and the carrier A being a copper foil, a copper alloy foil, or an aluminum foil.
The carrier-attached metal foil of the present invention yields numerous advantages as a result of the carrier A and the metal foil B both having a glossy surface (S surface), and the respective glossy surfaces being laminated to face each other, which is also a preferred mode of lamination.

As the metal foil B, a copper foil, a copper alloy foil, and an aluminum foil are typical examples and most favorable, but foils of nickel, zinc, iron, stainless and the like may also be used. Similarly, a foil of the same material as the metal foil B can be used as the carrier A. In the case of a copper foil, a copper alloy foil, or an aluminum foil, an electrolytic foil or a rolled foil with a thickness of 5 to 120 µm can be used.

Moreover, the coefficient of thermal expansion of the metal foil B is desirable within the range of +10%, -35% of the coefficient of thermal expansion of the carrier A. Consequently, it is possible to effectively prevent the misalignment of the circuit caused by the difference in thermal expansion, and thereby reduce defective products and improve the production yield.
Generally, since the carrier A and the metal foil B are mechanically peeled before the process of plating or etching or the like, the peel strength thereof is desirably 1 g/cm or more and 1 kg/cm or less. Moreover, the peeling surface is desirably the boundary of the carrier A and the metal foil B, and the residue of the other material will require a venting process thereof and cause the overall process to become complicated, and must be avoided.

This book was thereafter set in a hot press and subject to compression molding at a prescribed temperature and pressure to produce a four-layer substrate. Note that substrates with four or more layers can be generally produced with a similar process by increasing the number of layers of the inner layer core.
The laminated plate prepared as described above becomes a completed product by peeling and separating the carrier and copper foil, and subsequently forming a circuit via the plating process and/or etching process.
Since the entire surface of the metal foil B is supported with the carrier A, the metal foil was completely free of wrinkles during the lamination.

In addition, if a copper alloy foil is used as the carrier A and copper is used as the metal foil B, the linear expansion coefficient will basically be the same level as the copper foil as the constituent material of the substrate and the polymerized prepreg. Thus, the misalignment of the circuit will not occur. Accordingly, it was possible to reduce defective products and thereby improve the production yield compared to cases of using a conventional CAC.
It should be easy to understand that the advantages in the structure of the present invention are not affected by the material or thickness of the metal foil B and the carrier A.
Meanwhile, if the same foil as the copper alloy foil is used as the carrier, there is no need to alternately repeat the process of lamination so that the M surface of the copper foil is on top or the M surface is at the bottom, and the effect of alleviating the worker's operation is yielded.

### [Examples]

The Examples of the present invention are now explained. Note that these Examples are presented for facilitating the understanding of the invention, and this invention is not limited to the Examples. The present invention should be comprehended from the requirements described in the claims and the overall technical concept that is described in the supporting specification, and the present invention covers all of the above. Comparative examples are also presented in connection with the explanation of the Examples.

### (Bonding process in the Examples)

Generally, since the adhesive viscosity gradually changes after the adhesive is applied and hardened, a viscometer calibration standard solution, in which the viscosity change is minimal before and after the application, was used for the preliminary examination. Here, the calibration standard solution after the testing was measured with a shear apparatus, and it has been confirmed that there was no viscosity change. Moreover, since it is difficult to directly measure the viscosity of the adhesive in the air-vent process, the viscosity of the adhesive and the temporal change were measured in advance, and the viscosity of the adhesive was estimated based on the time from its application.
The adhesive that was used in the following Examples is acrylic, and the viscosity was adjusted by using adhesives in which the polymerization degree of the polymer material is different.
The adhesive was applied using a cylinder-type dispenser to achieve a thickness of 0.1 mg/cm². Air-vent was performed five seconds after the adhesive was applied. Here, air-vent was performed by rotating a PVC pipe of 50 mmϕ at a moving speed of 10 Cm/sec and at a pressure of 50 gf/Cm.

### (Example 1)

An aluminum foil of 40 µm was used as the carrier A, and a copper foil of 35 µm was used as the foil to be bonded thereto. An adhesive with a viscosity of 2,000,000 to 3,000,000 mPA·S was used, and applied at an application width of 3 mm at both facing ends while winding off the carrier A from a bobbin. The adhesive was applied linearly.
The metal foil B was laid on and bonded to a side to which the adhesive was applied while being wound off from a bobbin, the obtained laminated body was subsequently cut, the cut laminated bodies were aligned, and a roller was applied from the top of an object to be cut (air-vent).
Consequently, bonding was possible in a state that is free from the generation of wrinkles and cracks with the viscosity being 2,000,000 to 3,000,000 mPA•S.
When the viscosity was 5,000,000 mPA•S, wrinkles occurred and the laminated body became defective.

### (Example 2)

An aluminum foil of 12 µm was used as the carrier A, and a copper foil of 9 µm was used as the foil to be bonded thereto. An adhesive with a viscosity of 800,000 to 900,000 mPA·S was used, and applied at an application width of 3 mm. The adhesive was applied linearly. The process from bonding to roller application was the same as Example 1.
Since the carrier and the copper foil were thin, bonding was possible in a state that is free from the generation of wrinkles and cracks with the viscosity being 800,000 to 900,000 mPA·S, which is a range that is smaller than Example 1, even though some lenticulation could be observed.
Meanwhile, when the viscosity was 2,000,000 mPA•S, wrinkles occurred and the laminated body became defective.
Accordingly, it has been confirmed that it is necessary to adjust the viscosity of the adhesive to be applied depending on the material and thickness of the carrier A.

### (Example 3)

An aluminum foil of 18 µm was used as the carrier A, and a copper foil of 5 µm was used as the foil to be bonded thereto. An adhesive was applied linearly at an application width of 3 mm. The process from bonding to roller application was the same as Example 1.
In the foregoing case, since the copper foil was even thinner than Example 2, bonding was possible in a state that is free from the generation of wrinkles and cracks with the viscosity being 8000 to 10000 mPA·S, even though some lenticulation could be observed.
Meanwhile, when the viscosity was 1,500,000 mPA•S, wrinkles occurred and the laminated body became defective.
Accordingly, in this case also, it has been confirmed that it is necessary to adjust the viscosity of the adhesive to be applied depending on the material and thickness of the carrier A.

### (Example 4)

An aluminum foil of 18 µm was used as the carrier A, and a copper foil of 5 µm was used as the foil to be bonded thereto. An adhesive was applied in a dotted line (broken line) at an application width of 3 mm. The length of the applied broken line was 10 mm, and its interval was 30 mm. The process from bonding to roller application was the same as Example 1.
In the foregoing case also, since the copper foil was even thinner than Example 2, bonding was possible in a state that is free from the generation of wrinkles and cracks with the viscosity being 1000 to 5000 mPA•S, even though some lenticulation could be observed.
Meanwhile, when the viscosity was 1,200,000 mPA·S, wrinkles occurred and the laminated body became defective.
Accordingly, in this case also, it has been confirmed that it is necessary to adjust the viscosity of the adhesive to be applied depending on the material and thickness of the carrier A.

### INDUSTRIAL APPLICABILITY

The carrier-attached metal foil of the present invention is a rectangular laminated body in which a carrier A and a metal foil B alternately overlap, wherein proof stress or yield stress of the carrier A is 20 to 500 N/mm², and the carrier A and the metal foil B are bonded at ends of two facing sides with an adhesive having an adhesive strength of 5 g/cm to 500 g/cm. Thus, the worker's handling ability will improve, and peeling can also be performed easily.
In addition, it is possible to provide a production method that is free from wrinkles, cracks and peeling in the air-vent process.
Moreover, since the misalignment of the circuit will not occur, the present invention yields a superior effect of being able to reduce defective products and thereby improve the production yield.
Significant advantages are yielded by the laminated body as the carrier-attached metal foil obtained with the present invention, and this laminated body is particularly effective to produce a printed circuit board.

### Preferred Features

1. A method of producing a laminated body, wherein, while winding off a carrier A from a bobbin, an adhesive is applied to both facing ends thereof, a metal foil B is laid on and bonded to a side to which the adhesive was applied while being wound off from a bobbin, the obtained laminated body is subsequently cut, the cut laminated bodies are aligned, a roller is applied from the top of an object to be cut configured from the aligned laminated bodies when the elevation of the center of the object to be cut becomes high to vent air existing between the objects to be cut and in the laminated bodies, and the adhesive is eventually hardened to mutually bond the laminated bodies.
2. The method of producing a laminated body according to clause 1, wherein the roller is applied from the top of the object to be cut when the elevation of the center of the object to be cut configured from the aligned laminated bodies becomes greater than 10% of the thickness of four sides.
3. The method of producing a laminated body according to clause 1 or claim 2, wherein a carrier A having proof stress or yield stress of 20 to 500 N/mm² is used, and the carrier A and the metal foil B are bonded at ends of two facing sides with an adhesive having an adhesive strength of 5 g/cm to 500 g/cm in order to produce a rectangular laminated body in which the carrier A and the metal foil B alternately overlap.
4. The method of producing a laminated body according to any one of clauses 1 to 3, wherein an adhesive to be applied and used for bonding has a viscosity of 3,000,000 mPA·S (25°C) or less in the process of applying a roller from the top of the object to be cut and removing air existing between the objects to be cut and in the laminated bodies.
5. The method of producing a laminated body according to any one of clauses 1 to 3, wherein an adhesive to be applied and used for bonding has a viscosity of 1,000,000 mPA·S (25°C) or less in the process of applying a roller from the top of the object to be cut and removing air existing between the objects to be cut and in the laminated bodies.
6. The method of producing a laminated body according to any one of clauses 1 to 5, wherein [the adhesive] is applied at a portion otherthan an area to be used as a printed circuit board of the metal foil B for bonding the carrier A and the metal foil B.
7. The method of producing a laminated body according to any one of clauses 1 to 6, wherein the adhesive is applied in dots or linearly.
8. The method of producing a laminated body according to any one of clauses 1 to 7, wherein the position of applying the adhesive is disposed more outward than a laminated substrate material of a prepreg and/or core material to be subsequently bonded.
9. A rectangular laminated body in which a carrier A and a metal foil B alternately overlap, wherein proof stress or yield stress of the carrier A is 20 to 500 N/mm², and the carrier A and the metal foil B are bonded at ends of two facing sides with an adhesive having an adhesive strength of 5 g/cm to 500 g/cm.
10. The laminated body according to clause 9, wherein an adhesive having a viscosity of 3,000,000 mPA•S (25°C) or less after the lapse of three minutes from application is used.
11. The laminated body according to clause 9, wherein an adhesive having a viscosity of 1,000,000 mPA·S (25°C) or less after the lapse of three minutes from application is used.
12. The laminated body according to any one of clauses 9 to 11, wherein the adhesive is epoxy-based, acrylic, methacrylate-based, silicon rubber-based, ceramic-based, or rubber-based.
13. The laminated body according to any one of clauses 9 to 12, wherein the metal foil B is a copper foil, a copper alloy foil, an aluminum foil, a nickel foil, a zinc foil, an iron foil, or a stainless foil, and its thickness is 1 to 100 µm.
14. The laminated body according to any one of claims 9 to 13, wherein the same foil as the metal foil B is used as the carrier A.
15. The laminated body according to any one of clauses 9 to 14, wherein the adhesive is applied to a portion other than an area to be used as a printed circuit board of the metal foil B, and the carrier A and the metal foil B are bonded at such portion.
16. The laminated body according to any one of clauses 9 to 15, wherein the adhesive is applied in dots or linearly.
17. The laminated body according to any one of clauses 9 to 16, wherein the position of applying the adhesive is disposed more outward than a laminated substrate material of a prepreg and/or core material to be subsequently bonded.

## Claims

1. A rectangular laminated body in which a carrier A and a metal foil B alternately overlap, wherein the proof stress or yield stress of the carrier A is 20 to 500 N/mm², and the carrier A and the metal foil B are bonded at two side edges with an adhesive having an adhesive strength of 5 g/cm to 500 g/cm.

2. The laminated body according to claim 1, wherein the adhesive used has a viscosity of 3,000,000 mPA•s (25°C) or less, three minutes after application.

3. The laminated body according to claim 1, wherein the adhesive used has a viscosity of 1,000,000 mPA•s (25°C) or less, three minutes after application.

4. The laminated body of any preceding claim, wherein the adhesive is epoxy-based, acrylic, methacrylate-based, silicon rubber-based, ceramic-based, or rubber-based.

5. The laminated body according to any preceding claim, wherein the metal foil B is a copper foil, a copper alloy foil, an aluminium foil, a nickel foil, a zinc foil, an iron foil, or a stainless foil and its thickness is 1 to 100 µm.

6. The laminated body according to any preceding claim, wherein the same foil as the metal foil B is used as the carrier A.

7. The laminated body according to any preceding claim, wherein the adhesive is applied to a portion other than an area to be used as a printed circuit board of the metal foil B, and the carrier A and the metal foil B are bonded at such portion; AND/OR wherein the adhesive is applied in dots or linearly; AND/OR wherein the adhesive is applied outside the area where a laminated substrate material of a prepreg and/or a core material are to be subsequently bonded.
